(19) Europäisches Patentamt
European Patent Office
Office européen des brevets

(11) **EP 3 248 213 B1**

(12) **FASCICULE DE BREVET EUROPEEN**

(45) Date de publication et mention de la délivrance du brevet:
**06.09.2023 Bulletin 2023/36**

(21) Numéro de dépôt: **16703350.5**

(22) Date de dépôt: **21.01.2016**

(51) Classification Internationale des Brevets (IPC):
**H01L 21/20** [(2006.01)]

(52) Classification Coopérative des Brevets (CPC):
**H01L 21/02505; H01L 21/02381; H01L 21/02433; H01L 21/02458; H01L 21/02488; H01L 21/0254**

(86) Numéro de dépôt international:
**PCT/FR2016/050126**

(87) Numéro de publication internationale:
**WO 2016/116715 (28.07.2016 Gazette 2016/30)**

(54) **FABRICATION D'UN SUPPORT SEMI-CONDUCTEUR À BASE DE NITRURES D'ÉLÉMENTS III**

HERSTELLUNG EINES HALBLEITERTRÄGERS AUF BASIS VON GRUPPE-III-NITRIDEN

PRODUCTION OF A SEMICONDUCTOR SUPPORT BASED ON GROUP III NITRIDES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.01.2015 FR 1550462**

(43) Date de publication de la demande:
**29.11.2017 Bulletin 2017/48**

(73) Titulaire: **Centre National de la Recherche Scientifique (C.N.R.S.)
75016 Paris (FR)**

(72) Inventeurs:
- **SEMOND, Fabrice
  06400 Cannes (FR)**
- **MASSIES, Jean
  06560 Valbonne (FR)**
- **FRAYSSINET, Eric
  06370 Mouans Sartoux (FR)**

(74) Mandataire: **Atout PI Laplace
Immeuble "Visium"
22, avenue Aristide Briand
94117 Arcueil Cedex (FR)**

(56) Documents cités:
**US-A1- 2002 069 817    US-A1- 2004 137 732
US-A1- 2012 091 467    US-A1- 2013 178 050**

- **TAEIL JUNG ET AL: "Novel Epitaxial Nanostructures for the Improvement of InGaN LEDs Efficiency", IEEE JOURNAL OF SELECTED TOPICS IN QUANTUM ELECTRONICS, IEEE SERVICE CENTER, PISCATAWAY, NJ, US, vol. 15, no. 4, 1 juillet 2009 (2009-07-01), pages 1073-1079, XP011344247, ISSN: 1077-260X, DOI: 10.1109/JSTQE.2009.2016437**
- **KAPPERS ET AL: "Threading dislocation reduction in (0001) GaN thin films using SiNx interlayers", JOURNAL OF CRYSTAL GROWTH, ELSEVIER, AMSTERDAM, NL, vol. 300, no. 1, 28 février 2007 (2007-02-28), pages 70-74, XP005915215, ISSN: 0022-0248, DOI: 10.1016/J.JCRYSGRO.2006.10.205**
- **LEBEDEV V ET AL: "The role of Si as surfactant and donor in molecular-beam epitaxy of AIN", JOURNAL OF APPLIED PHYSICS, AMERICAN INSTITUTE OF PHYSICS, US, vol. 98, no. 9, 4 November 2005 (2005-11-04), pages 93508-093508, XP012078893, ISSN: 0021-8979, DOI: 10.1063/1.2126786**

**Description**

## DOMAINE DE L'INVENTION

L'invention concerne un procédé de fabrication d'une structure semi-conductrice à base de nitrures d'éléments III et une telle structure semi-conductrice.

## PRESENTATION DE L'ART ANTERIEUR

Les matériaux semi-conducteurs à base de nitrures d'éléments III du tableau périodique - tels que les matériaux à base de nitrure de gallium GaN - occupent une place de plus en plus importante dans les domaines de l'électronique et de l'optoélectronique, notamment pour la fabrication de diodes électroluminescentes.

Les procédés existants de fabrication d'une structure semi-conductrice à base de nitrures d'éléments III, tel que le nitrure de gallium GaN sur un substrat, par exemple en silicium ou en saphir, résultent généralement en une densité de dislocations traversantes importante liée à la différence de paramètre de maille entre le substrat hôte et les matériaux semi-conducteurs à base de nitrures d'éléments III. Ces dislocations traversantes sont particulièrement pénalisantes dans le cas de structures semi-conductrices formant des dispositifs d'émission de lumière à base de matériaux semi-conducteurs de nitrures d'éléments III puisque les dislocations traversantes augmentent les courants de fuites et détériorent le rendement de luminescence de ces dispositifs d'émission de lumière.

Les techniques d'épitaxie tridimensionnelle - telles que la surcroissance latérale (ELO de l'anglais « epitaxial lateral overgrowth »), la pendeo-épitaxie à partir de nano-piliers, l'ajout d'espèces antisurfactantes, la modification des conditions de croissance - ont prouvé leur efficacité pour réduire la densité de dislocations traversantes dans les matériaux semi-conducteurs à base de nitrures d'éléments III. L'approche utilisée par ces techniques pour réduire la densité de dislocations traversantes consiste à initier un mode de croissance tridimensionnelle (par îlot), puis à favoriser la coalescence des îlots pour obtenir une couche bidimensionnelle de nitrure gallium GaN.

Une technique in-situ populaire pour réduire la densité de dislocations traversantes consiste à insérer une couche intercalaire de nitrure de silicium SiNx en dessous de la couche de GaN. Plus précisément, une couche de nitrure de silicium SiNx est déposée in-situ sur une couche de nitrure d'élément III, puis une couche de nitrure de gallium GaN est déposée sur la couche nitrure de silicium SiNx. Cette technique a prouvé son efficacité pour réduire la densité de dislocations traversantes pour le GaN plan-c conventionnel mais aussi pour les orientations semi-non polaires.

Il est reconnu qu'un traitement de surface à base de silicium et d'ammoniac conduit à la formation d'une couche nano-poreuse de nitrure de silicium SiNx qui agit comme un nano-masque permettant d'initier un mode de croissance tridimensionnel du GaN. La croissance de GaN est inhibée dans les régions où se trouve le nitrure de silicium SiNx. En revanche la croissance se produit dans les nano-pores, c'est-à-dire dans les ouvertures du nano-masque. La densité et la taille de ces derniers sont contrôlées par le temps de dépôt du nitrure de silicium SiNx et leur répartition à la surface est aléatoire.

Par exemples, les documents suivants traitent de ces sujets :

- L'article intitulé "A New Method of Reducing Dislocation Density in GaN Layer Grown on Sapphire Substrate by MOVPE" par Sakai et al., J. Cryst. Growth, 221, 334 (2000),
- l'article intitulé "Anti-Surfactant in III-Nitride Epitaxy - Quantum Dot Formation and Dislocation Termination" par S. Tanaka et al., Jap. J. Appl. Phys., 39, L83 1 (2000),
- l'article "Efficacy of single and double SiNx interlayers on defect réduction in GaN overlayers grown by organometallic vapor-phase epitaxy", par F. Yun et al., J. Appl. Phys., 98, 123502 (2005),
- la demande de brevet DE10151092 A1,
- la demande de brevet WO2007/133603 A2.

Par exemple, le document US 2004/0137732 propose de déposer sur un substrat un film de nitrure de silicium faisant fonction de masque présentant des discontinuités ou des ouvertures, puis de procéder au dépôt d'une fine couche de nitrure de gallium à basse température avant de procéder à un recuit thermique. Le recuit permet de faire localiser le nitrure de gallium au niveau des ouvertures du masque afin d'obtenir des îlots de nitrure de gallium qu'exploite une croissance ultérieure de nitrure de gallium.

Il a récemment été montré que ce type de traitement pouvait aussi conduire à la formation d'une structure cristalline notée $3^{1/2} x 3^{1/2}$ R30°, notamment dans l'article "Blocking Growth by Electrically Active Subsurface Layer : The Effects of Si as an Antisurfactant in the Growth of GaN", par T. Markurt et al. Physical Review Letters 110, 036103 (2013). Dans cet article, la couche cristalline est fabriquée de façon à obtenir une surface partiellement recouverte, avec des régions plus ou moins grandes non recouvertes que l'on appelle « ouvertures » et cette couche est dite « nanoporeuse ».

**EP 3 248 213 B1**

Lebedev V. et al.: "The rôle of Si as surfactant and donor in molecular-beam epitaxy of AlN", Journal of Applied Physics, Institute of Physics, US, vol. 98, no. 9, 4 novembre 2005, pages 93508-093508, divulgue un procédé selon le préambule de la revendication 1.

Lors de l'étape de dépôt de la couche de nitrure de gallium GaN, le nitrure de gallium épitaxié croît préférentiellement dans les ouvertures de la couche nanoporeuse de sorte à former des îlots. Une fois les îlots formés, les paramètres de croissance sont ajustés pour que le nitrure de gallium GaN se développe latéralement de sorte à recouvrir les zones couvertes de SiNx, et coalescent afin de former une couche de nitrure de gallium GaN (croissance 3D). La croissance de la couche de nitrure de gallium est ensuite poursuivie jusqu'à l'obtention d'une épaisseur de nitrure de gallium GaN désirée (croissance 2D). L'épaisseur de coalescence du nitrure de gallium GaN est définie comme l'épaisseur requise pour obtenir une couche de GaN entièrement coalescée après l'insertion de la couche de SiNx.

Le lecteur aura compris que l'augmentation de la durée du traitement de surface, et donc de la quantité de SiNx déposé, a pour effet d'augmenter le taux de couverture de la couche SiNx et donc de diminuer la densité d'îlots de nitrure de gallium GaN, ce qui permet de diminuer la densité de dislocations traversantes. En revanche, plus la densité d'îlots de nitrure de gallium GaN est faible, plus l'épaisseur de de niture de gallium GaN requise pour obtenir la coalescence est importante. Il est donc particulièrement avantageux de déterminer le taux de couverture optimum de la couche de SiNx pour rendre un tel procédé exploitable industriellement.

De plus, les procédés existants de fabrication de dispositifs à base de GaN sur un substrat comprennent généralement une première étape de dépôt d'une couche tampon, laquelle peut être par exemple du nitrure d'aluminium AlN pour un substrat silicum éventuellement suivie d'une étape de dépôt d'une couche de nitrure d'aluminium et gallium AlGaN sur la couche tampon de nitrure d'aluminium AlN. Le nano-masque peut ensuite être déposé sur la couche d'AlN ou d'AlGaN. D'autres procédés prévoient d'utiliser un substrat saphir et de déposer une couche de GaN à basse température en tant que couche tampon, auquel cas le nano-masque est déposé sur la couche tampon de GaN.

Un inconvénient de la technique de croissance avec le nano-masque de SiNx évoquée concerne le fait que des réactions d'oxydation peuvent avoir lieu à la surface de la couche tampon non recouverte par la couche de SiNx. Notamment, la couche tampon peut s'oxyder au niveau des ouvertures en cas d'exposition à l'air du support constitué du substrat, de la couche tampon et de la couche de SiNx. Par conséquent, dans les procédés de l'état de la technique, la couche de nitrure de gallium GaN supérieure (ou finale) est formée sur la couche SiNx immédiatement après la formation de celle-ci, sans possibilités de stockage du support préalablement au dépôt d'une couche de nitrure de gallium sur celui-ci.

Un autre inconvénient de cette technique concerne le fait qu'il n'existe aucun moyen permettant de définir la durée optimale de l'étape de dépôt de la couche nanoporeuse de SiNx. Cette durée optimale, liée à la taille des ouvertures et leur densité, varie en fonction du substrat de départ utilisé pour la croissance, du type de réacteur utilisé pour la croissance, et d'autres paramètres tels que les concentrations en précurseurs gazeux etc. La taille des ouvertures et leur densité sont des quantités non mesurables donc la détermination de la durée optimale de l'étape de dépôt de la couche nanoporeuse de SiNx ne peut donc être obtenue que de manière empirique en réalisant des essais successifs qui doivent être réitérés à chaque fois que l'un des paramètres de croissance (i.e. substrat, réacteur, etc.) est modifié, ce qui est coûteux en temps et surtout ne permet pas de réaliser un procédé générique, c'est-à-dire applicable de façon générale.

Un but de la présente invention est de proposer un procédé permettant de pallier au moins l'un des inconvénients précités.

## RESUME DE L'INVENTION

A cet effet, l'invention propose un procédé de fabrication d'un support pour la fabrication d'une structure semi-conductrice à base de nitrures d'éléments III selon la revendication 1.

Le fait de déposer une couche cristalline qui recouvre la totalité de la surface de la couche tampon sur le substrat permet de passiver totalement la surface de la couche tampon et donc d'empêcher toute réaction d'oxydation de cette dernière. Ceci rend possible le stockage du support composé du substrat, de la couche tampon et de la couche cristalline préalablement au dépôt de la structure semi-conductrice à base de nitrures d'éléments III.

L'étape de dépôt d'une couche cristalline qui recouvre la totalité de la surface permet en outre de s'affranchir des phases empiriques de mise au point et d'optimisation des procédés de l'art antérieur basés sur une étape de dépôt d'une couche nanoporeuse de SiNx, notamment la détermination de la taille optimum des nanopores ainsi que de la densité optimum des nanopores.

L'étape de dépôt d'une couche cristalline à base de silicium permet en outre une croissance ultérieure d'une couche à base de nitrure d'éléments III sur celle-ci, alors qu'une couche amorphe nanoporeuse recouvrant la couche supérieure à base de nitrure d'éléments III ne permettrait pas cette croissance ultérieure. L'image de diffraction décrite correspond à un arrangement périodique hexagonal tourné de 30° par rapport au réseau de la couche à base de nitrure d'éléments III et de paramètre de maille $\sqrt{3}$ fois plus grand que le paramètre de maille du réseau de la couche à base de nitrure d'éléments III, qui permet de favoriser cette croissance ultérieure d'une couche cristalline.

Il sera entendu dans la suite que lorsqu'une couche A est mentionnée comme étant sur une couche B, celle-ci peut être directement sur la couche B, ou peut être située au-dessus de la couche B et séparée de ladite couche B par une ou plusieurs couches intermédiaires.

Il sera également entendu que lorsqu'une couche A est mentionnée comme étant sur une couche B, celle-ci peut couvrir toute la surface de la couche B, ou une portion de ladite couche B.

Des aspects préférés mais non limitatif du dispositif selon l'invention sont les suivants :

- la couche cristalline est en relation épitaxiale avec la couche de nitrure d'éléments III;
- la couche cristalline est déposée à partir d'atomes de silicium et d'atomes d'azote, par exemple apporté par de l'ammoniac;
- la couche cristalline présente une périodicité simple suivant la direction cristallographique [1-210] de sorte qu'une image de diffraction de ladite couche cristalline obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci;
- le substrat est à base de silicium et l'étape de formation de la couche tampon inclut le dépôt d'une couche de nitrure d'aluminium AlN formant la couche de surface supérieure à base de nitrures d'éléments III ;
- le substrat est à base de silicium et l'étape de formation de la couche tampon inclut

  - le dépôt d'une couche de nitrure d'aluminium AlN et
  - le dépôt d'une couche une couche de nitrure de gallium et d'aluminium AlGaN formant la couche de surface supérieure à base de nitrures d'éléments III sur la couche de nitrure d'aluminium AlN ;

- la couche tampon a, à l'issue de sa formation, une épaisseur comprise entre 10 et 200 nm ;
- l'étape de dépôt de la couche cristalline consiste en un dépôt sous ultra-vide ;
- l'étape de dépôt de la couche cristalline consiste en un dépôt par épitaxie par jets moléculaires ;
- le procédé comprend une étape de mesure de la couche cristalline par diffraction d'électrons en incidence rasante suivant la direction cristallographique [1-100] pendant l'étape de dépôt de la couche cristalline de sorte à obtenir une image de diffraction de ladite couche cristalline, et la durée de l'étape de dépôt de la couche cristalline est fonction de l'intensité d'au moins une raie de diffraction de l'image de diffraction de la couche cristalline suivant la direction cristallographique [1-100];
- l'étape de dépôt de la couche cristalline consiste en un dépôt en phase vapeur ;
- l'étape de dépôt de la couche cristalline consiste en un dépôt par épitaxie en phase vapeur aux organométalliques ;
- la couche cristalline est déposée à partir d'atomes de silicium et de molécules d'ammoniac.

L'invention concerne également un support pour la fabrication d'une structure semi-conductrice à base de nitrures d'éléments III, selon la revendication 12.

L'état de la couche cristalline, en particulier son taux de couverture de la surface sous-jacente, i.e. la surface de la couche tampon, correspond à un maximum d'intensité lumineuse des raies intermédiaires d'ordre non-entier de l'image de diffraction suivant la direction cristallographique [1-100].

Des aspects préférés mais non limitatif du support selon l'invention sont les suivants :

- la couche cristalline est en relation épitaxiale avec la couche de nitrure d'éléments III;
- la couche cristalline inclue également des atomes d'azote;
- la couche cristalline présente une périodicité simple suivant la direction cristallographique [1-210] de sorte qu'une image de diffraction de ladite couche cristalline obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci ;
- le substrat est à base de saphir Al2O3, de silicium Si, de silicium sur isolant SOI, de carbure de silicium SiC, de nitrure d'aluminium AlN, d'oxyde de zinc ZnO ou d'arséniure de gallium GaAs ;
- le substrat est à base de silicium et la couche tampon comprend une couche de nitrure d'aluminium AlN et une couche de nitrure de gallium et d'aluminium AlGaN sur la couche de nitrure d'aluminium AlN ;
- la couche cristalline présente une épaisseur comprise entre 2 Å et 6 Å ;
- la couche tampon a une épaisseur comprise entre 10 et 200 nm.

L'invention concerne également un procédé de fabrication d'une structure semi-conductrice à base de nitrures d'éléments III, comprenant les étapes de

- fourniture d'un support selon l'invention,
- croissance d'une structure semi-conductrice à base de nitrures d'éléments III sur la couche cristalline.

De préférence, l'étape de croissance est effectuée à une température comprise entre 950 et 1200°C, et préférence entre 1000°C et 1100°C. De préférence également, l'étape de croissance ne comprend pas d'étape de recuit. De préférence encore, l'étape de croissance comprend la croissance d'une couche à base de nitrures d'éléments III sur la couche cristalline présentant une épaisseur supérieure à 1 $\mu$m, et de préférence supérieure à 2 $\mu$m.

De préférence, l'étape de croissance comprend une étape de dépôt d'une couche de nitrure de gallium GaN sur la couche cristalline. De préférence, l'étape de croissance consiste en un dépôt par épitaxie en phase vapeur aux organométalliques.

L'invention concerne également une structure semi-conductrice à base de nitrures d'éléments III, comprenant :

- un support selon l'invention,
- un matériau semi-conducteur à base de nitrures d'éléments III sur la couche cristalline.

De préférence, le matériau semi-conducteur à base de nitrures d'éléments III sur la couche cristalline comprend une couche de nitrure de gallium. Le nitrure de gallium GaN présente une densité de dislocations traversantes inférieure ou égale à $5.10^8$ cm$^{-2}$. De préférence, le matériau semi-conducteur à base de nitrures d'éléments III sur la couche cristalline comprend une couche à base d'aluminium.

L'invention concerne également une diode électroluminescente à base de nitrures d'éléments III, caractérisé en ce qu'elle comprend

- une structure semi-conductrice selon l'invention,
- une première couche de contact à base de nitrure de gallium disposée sur la première couche de semi-conducteur à base de nitrures d'éléments III,
- une seconde couche de contact à base de nitrure de gallium disposée sur la première couche de contact à base de nitrure de gallium,
- une couche active dotée d'une structure de puits quantiques multiples disposée entre la première couche de contact à base de nitrure de gallium et la seconde couche de contact à base de nitrure de gallium.

## BREVE DESCRIPTION DES DESSINS

D'autres avantages et caractéristiques du procédé selon l'invention et du produit associé ressortiront mieux de la description qui va suivre de plusieurs variantes d'exécution, données à titre d'exemples non limitatifs, à partir des dessins annexés sur lesquels :

- la figure 1 illustre un exemple de procédé de fabrication d'une structure semi-conductrice à base de nitrures d'éléments III ;
- la figure 2 illustre schématiquement un exemple de produit obtenu en mettant en oeuvre le procédé illustré à la figure 1,
- les figures 3 et 4 illustrent deux images de diffraction suivant les directions cristallographiques [1-100] et [1-210], respectivement, d'une couche cristalline selon l'invention,
- la figure 5 illustre une structure semi-conductrice ayant une structure mésa;
- la figure 6 illustre une structure semi-conductrice ayant une structure caisson;
- la figure 7 illustre une courbe représentative de l'évolution temporelle de l'intensité des raies d'ordre non entier d'une image de diffraction lors du dépôt d'une couche cristalline.

Dans les différentes figures, les mêmes références désignent des éléments similaires.

## DESCRIPTION DETAILLEE DE L'INVENTION

On va maintenant décrire plus en détail le procédé selon l'invention en référence à la croissance d'une couche de nitrure de gallium GaN sur un support, permettant de produire des diodes électroluminescentes. La couche à base de nitrures d'éléments III peut être une couche épaisse (« template » en anglais) ou auto-supportée, dit également substrat massif (« bulk substrate » en anglais). La structure semi-conductrice à base de nitrure d'éléments III peut ainsi être une couche épaisse GaN, AlN etc ..., ou un substrat massif GaN, AlN etc ..., ou bien encore un structure épitaxée ("epiwafer" en anglais).

Toutefois, il est bien évident pour l'homme du métier que le procédé décrit ci-après peut être utilisé pour faire croître un matériau à base de nitrures d'éléments III autre que du nitrure de gallium, ce matériau pouvant être utilisée pour réaliser d'autres structures semi-conductrices que des diodes électroluminescentes. Par exemple, la structure obtenue peut ainsi présenter une configuration de diode électroluminescente, ou de transistor à grande mobilité d'électrons (HEMT de l'anglais « high electron mobility transistor »).

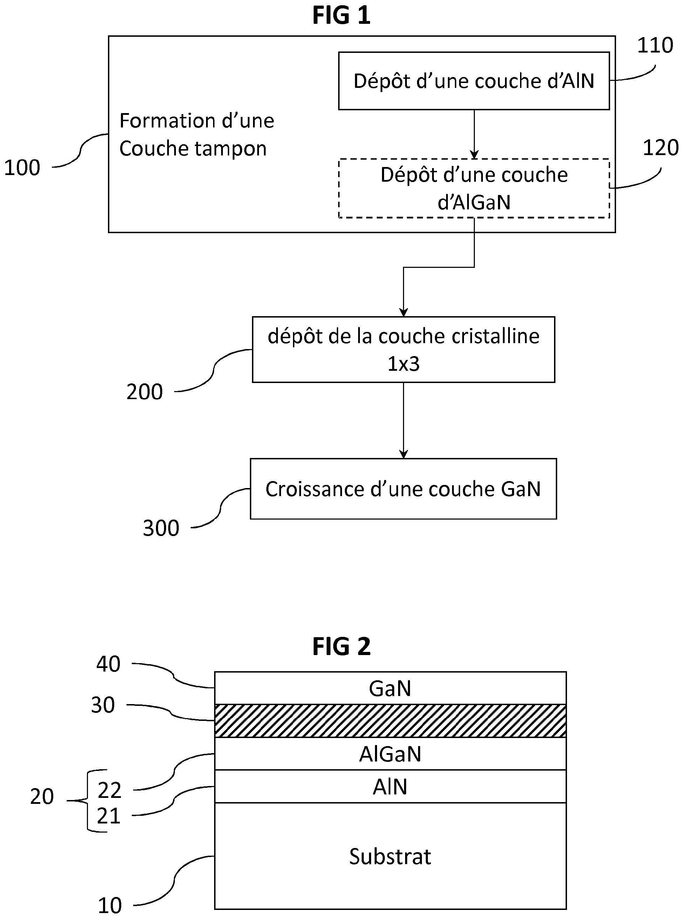

On a illustré à la figure 1 une variante de réalisation du procédé selon l'invention. Le procédé comprend les étapes consistant à :

- former 100 une couche tampon sur un substrat, ladite couche tampon comprenant une couche de surface supérieure à base de nitrures d'éléments III
- déposer 200 une couche cristalline sur la couche tampon,
- faire croître 300 une couche de nitrure de gallium sur la couche cristalline, ladite couche cristalline étant déposée à partir d'atomes de silicium.

*Substrat*

Pour fabriquer la structure semi-conductrice, on utilise un substrat 10 sur lequel différentes étape de dépôt sont mises en oeuvre.

Le substrat 10 utilisé peut être du saphir Al2O3, du silicium Si, du carbure de silicium SiC, du nitrure d'aluminium AlN, de l'oxyde de zinc ZnO ou de l'arséniure de gallium GaAs. Dans un mode de réalisation, le substrat est du silicium.

L'utilisation d'un substrat de silicium présente de nombreux avantages par rapport à l'utilisation d'un substrat de saphir ; notamment :

- un substrat de silicium est moins onéreux qu'un substrat de saphir ;
- les dimensions des substrats de silicium (généralement jusqu'à 12 pouces, soit 30,48 cm) sont plus importantes que celles des substrats de saphir (généralement jusqu'à 6 pouces, soit 15,24 cm) ; il est donc possible de fabriquer une couche de nitrure de gallium GaN de plus grande surface en utilisant un substrat de silicium ;
- les différentes étapes de fabrication des composants post-croissance (polissage face arrière, report face avant, retrait du substrat, etc.) après la croissance de la couche de nitrure de gallium GaN sont plus simples et moins coûteuses dans le cas de l'utilisation d'un substrat de silicium que dans le cas d'un substrat de saphir.

Ainsi, l'utilisation de substrats de silicium permet par exemple la fabrication de diodes électroluminescentes (LED) à bas coût de production, ce qui peut être particulièrement avantageux dans le domaine de l'éclairage.

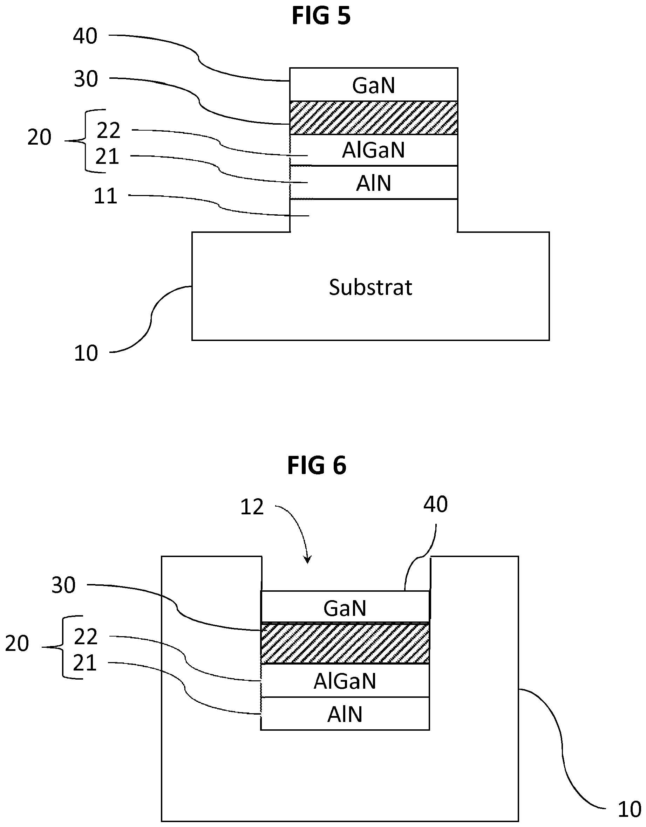

Avantageusement, le substrat 10 peut être un substrat à motif comprenant une structure mésa 11 ayant la forme d'un plateau surélevé (dont la taille peut varier de 10x10 $\mu$m à 400x400 $\mu$m) et obtenu par gravure de la surface du substrat entourant le plateau, comme illustré sur la figure 5, ou bien encore une structure caisson, comme représenté sur la figure 6, dans laquelle la couche tampon 20 à base de nitrure d'éléments III, en l'espèce en AlN et en AlGaN, la couche cristalline 30 la recouvrant totalement et la couche de nitrure de gallium 40 sont situées dans un renfoncement 12 ménagé dans le substrat 10. Un autre procédé de fabrication des motifs, comme par exemple le masquage partiel de la surface par un masque en matériaux diélectriques, peut être avantageusement utilisé.

L'utilisation d'un tel substrat à motif permet de limiter la fissuration de la couche de nitrure de gallium 40 épitaxiée sur le substrat 10, et ainsi d'augmenter l'épaisseur critique de nitrure de gallium GaN que l'on peut déposer sur le substrat 10 sans créer de fissures.

Par exemple, il est possible de réaliser une couche non fissurée de nitrure de gallium GaN d'épaisseur 5 $\mu$m en utilisant un substrat incluant une structure mésa de 200$\times$200$\mu$m alors que l'utilisation d'un substrat non structuré ne permet de réaliser qu'une couche non fissurée de nitrure de gallium GaN d'épaisseur 1 $\mu$m.

*Formation de la couche tampon*

Le procédé comprend une étape de formation 100 d'une couche tampon 20 comprenant une couche de surface supérieure à base de nitrures d'éléments III. Cette couche tampon peut par exemple comprendre une couche de nitrure d'aluminium AlN, de nitrure d'aluminium-gallium AlGaN, de nitrure d'aluminium-gallium-bore AlGaBN, un empilement AlN/AlGaN, un graduel AlGaN, de l'oxyde de zinc ZnO, ou encore du nitrure de bore BN ou encore de carbure de silicium SiC. Cependant, dans tous les cas, la couche tampon présente une couche supérieure à base de nitrures d'éléments III, tel que le nitrure d'aluminium AlN, le nitrure d'aluminium-gallium AlGaN.

Dans le cas de l'exemple de la présente description, cette étape de formation 100 comprend le dépôt 110 d'une couche 21 de nitrure d'aluminium AlN sur le substrat 10. Cette couche 21 de nitrure d'aluminium AlN peut constituer la couche de surface supérieure à base de nitrures d'éléments III de la couche tampon 20.

La formation d'une couche tampon 20 incluant une couche 21 de nitrure d'aluminium AlN permet d'améliorer la qualité de la couche 40 de nitrure de gallium GaN déposée ultérieurement.

Par exemple, lorsque le substrat 10 utilisé est du silicium Si, la croissance directe de nitrure de gallium GaN sur le silicium Si est très difficile du fait notamment de la haute réactivité chimique entre le gallium Ga, le silicium Si à haute température.

La formation d'une couche tampon 20 incluant une couche 21 de nitrure d'aluminium AlN permet de remédier à ces difficultés, et donc d'améliorer la qualité de la couche 40 de nitrure de gallium GaN épitaxiée.

La couche tampon 20 peut présenter une épaisseur comprise entre 10 nm et 500 nm, préférentiellement entre 10 $\mu$m et 200 nm. Une couche tampon avec une épaisseur supérieure à 200 nm permet d'obtenir une bonne qualité cristalline de la couche tampon 20, et donc d'améliorer celle de la couche de nitrure d'éléments III épitaxiée ultérieurement.

La couche cristalline selon l'invention, qui recouvre totalement la couche tampon, permet cependant d'assurer une bonne qualité cristalline de la couche de nitrure d'éléments III épitaxiée ultérieurement même si la qualité cristalline de la couche tampon n'est pas maximale. Par conséquent, il n'est pas nécessaire que la couche tampon 20 atteigne une épaisseur supérieure à 200 nm. Ainsi, de préférence, la couche tampon 20 présente une épaisseur comprise entre 10 et 200 nm, voire entre 50 et 100 nm.

Le fait de limiter l'épaisseur de la couche tampon 20 en deçà de 200 nm permet avantageusement de réduire la durée du procédé, le temps de croissance d'une couche 21 de nitrure d'aluminium AlN étant relativement long. Un autre avantage est le fait qu'avec une couche tampon 20 peu épaisse, qui se trouve recouverte en totalité par une couche cristalline, le problème des dislocations dans cette couche tampon résolu par la couche cristalline 30 s'en trouve d'autant plus rapidement résolu, ce qui empêche les dislocations de se propager et de provoquer des dislocations.

L'étape de formation 100 de la couche tampon 20 peut également comprendre une étape optionnelle de dépôt 120 d'une couche 22 de nitrure d'aluminium et de gallium AlGaN sur la couche 21 de nitrure d'aluminium AlN. Cette couche 22 de nitrure d'aluminium et de gallium AlGaN forme alors la couche de surface supérieure à base de nitrure d'éléments III de la couche tampon 20.

Ceci permet d'obtenir une couche tampon complexe 20 de nitrure d'aluminium AlN et de nitrure d'aluminium et de gallium AlGaN.

La couche 22 de nitrure d'aluminium et de gallium AlGaN permet de réduire la densité de dislocation de la couche sur laquelle la couche cristalline est déposée.

Avantageusement, l'épaisseur de la couche tampon, et donc éventuellement la somme des épaisseurs des couches 21, 22 de nitrure d'aluminium AlN et de nitrure d'aluminium et de gallium AlGaN peut être comprise entre 10 nm et 500 nm, de préférence entre 50 et 200 nm avec par exemple la répartition suivante :

- 25-100 nm de nitrure d'aluminium AlN,
- 25-400 nm de nitrure d'aluminium et de gallium AlGaN.

Ceci permet de réduire la durée de croissance de la couche tampon tout en bénéficiant des avantages relatifs au dépôt de couches de nitrure d'aluminium et de nitrure d'aluminium et de gallium.

De préférence, la surface de la couche tampon, c'est-à-dire la surface de la couche à base de nitrures d'éléments III, sur laquelle va être déposée la couche cristalline, est formée aussi lisse que possible.

A cet effet, il est avantageux de réaliser le traitement de surface de la couche tampon 20 à une température inférieure à 950°C sous un flux d'atomes de silicium et un flux d'atomes d'azote, par exemple des molécules d'ammoniac NH3, dans un réacteur d'épitaxie par jets moléculaires. Ce faisant, la surface ne se dégrade pas et reste lisse.

*Dépôt d'une couche cristalline*

Le procédé comprend également une étape de dépôt 200 d'une couche cristalline 30 épitaxiale sur la couche tampon 20. La couche cristalline est déposée à partir d'un précurseur contenant des atomes de silicium Si, et éventuellement des atomes d'azote. Le précurseur contenant des atomes de silicium peut par exemple être le silane $SiH_4$, le disilane $Si_2H_6$, ou le trimethylsilane $SiH(CH_3)_3$. Des atomes d'azote peuvent être apportés, par exemple par des molécules d'ammoniac NH3.

La couche cristalline 30 est déposée de sorte de recouvrir la totalité la surface de la couche tampon 20, constituée par la surface supérieure de la couche à base de nitrures d'éléments III, par exemple la couche 21 de nitrure d'aluminium ou la couche 22 de nitrure de gallium. La couche cristalline 30 est déposée de sorte à être en épitaxie avec la couche de nitrure d'éléments III, i.e. en relation épitaxiale avec la couche de nitrure d'éléments III.

L'étape de dépôt de la couche cristalline 30 correspond à un traitement de surface qui conduit à une reconstruction de surface des atomes déposés à la surface de la couche tampon 20.

En effet, suite à l'exposition de la surface de la couche tampon 20 aux atomes de silicium Si et éventuellement aux molécules d'ammoniac NH3, des atomes de silicium Si, et éventuellement d'azote, se lient à la surface de la couche tampon en créant un arrangement hexagonal tourné de 30° par rapport au réseau de la couche à base de nitrure d'éléments III sur laquelle les atomes sont déposés et avec un paramètre de maille $\sqrt{3}$ fois plus grand que celui de la couche à base de nitrure d'éléments III.

La formation de cette reconstruction de surface est mesurable par des techniques de diffraction électronique et on peut quantifier son taux de couverture de la surface en enregistrant l'intensité des raies de diffraction spécifiques de cette reconstruction de surface.

La diffraction des électrons est une technique utilisée pour l'étude de la matière qui consiste à bombarder d'électrons un échantillon et à observer la figure de diffraction résultante.

Un exemple de technique de diffraction électronique utilisable dans le cadre de la présente invention pour étudier la structure de la couche cristalline est la diffraction d'électrons de haute énergie en réflexion ("reflection high energy electron diffraction" en anglais ou RHEED), qui est une technique permettant de déterminer la structure cristalline de la surface dans un environnement ultra-vide.

La technique RHEED permet notamment de déterminer la reconstruction de la surface, de mesurer la vitesse de croissance et d'apprécier qualitativement la planéité de la surface. Un dispositif RHEED consiste en un canon à électrons qui permet de créer un faisceau d'électrons monocinétique d'une énergie de 10 à 50 keV focalisé sur la surface. La longueur d'onde associée aux électrons est de l'ordre de 0.1 Å. Le faisceau atteint la surface en incidence rasante avec un angle de 1 à 2 degrés. Dans cette configuration l'interaction des électrons avec la surface se limite à quelques plans atomiques. Les électrons réfléchis et diffractés par les atomes de la surface sont collectés sur un écran fluorescent qui permet de visualiser le cliché de diffraction correspondant et ce cliché peut ensuite être numérisé à l'aide d'une caméra CCD. Le document "Reflection High Energy Electron Diffraction", par Ayahiko Ichimiya et Philip I. Cohen, Cambridge University Press, 2004, décrit cette technique.

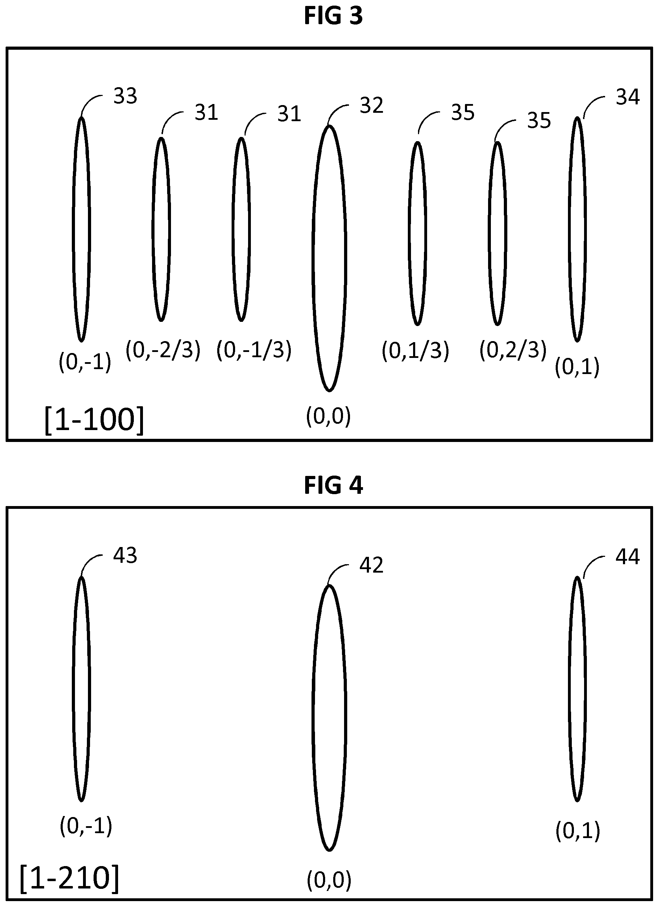

En référence aux figures 3 et 4, on a illustré deux images de diffraction de la couche cristalline suivant les directions cristallographiques respectives [1-100] et [1-210].

Dans la figure 4, l'image de diffraction de la couche cristalline selon la direction [1-210] comprend uniquement des raies de diffraction d'ordre entier: une raie centrale (0,0) 42 et deux raies d'ordre entier (0, -1) 43 et (0, 1) 44 de part et d'autre de ladite raie centrale 42. Ainsi il n'y a pas de raies d'ordre non-entier entre les raies d'ordre entiers (0,-1) et (0, 1) et la raie centrale (0, 0). Il est à noter que l'écartement entre des raies de diffraction d'ordre entier est inversement proportionnel au paramètre de maille dans le plan de la surface.

Dans la figure 3 en revanche, correspondant à l'image de diffraction de la couche cristalline selon la direction [1-100], la présence d'une reconstruction de surface conduit à la présence de raies supplémentaires d'ordre fractionnaire, c'est-à-dire d'ordre non-entier, en l'occurrence d'ordre 1/3 caractéristique d'une reconstruction dite 1x3. L'image de diffraction de la couche cristalline selon la direction [1-100] comprend ainsi :

- une raie centrale (0, 0) et des raies d'ordre entier (0, -1) et (0, 1),
- deux raies de diffraction d'ordre non-entier 31, dites (0,-1/3) et (0, -2/3), entre les raies (0, 0) 32 et (0, -1) 33, et
- deux raies de diffraction d'ordre non-entier 35, dites (0, 1/3) et (0, 2/3), entre les raies (0, 0) 32 et (0, 1) 34.

Par conséquent, l'image de diffraction suivant la direction [1-210] ne présentant qu'un espace entre les raies d'ordre entier, alors que l'image de diffraction suivant la direction [1-100] présentant trois espaces entre les raies d'ordre entier, c'est pourquoi cette couche cristalline est dénommée 1x3.

Ainsi, et contrairement aux procédés de l'art antérieur comprenant une étape de dépôt d'une couche nanoporeuse de SiNx dont la structure et la composition exacte sont inconnues, le procédé selon l'invention propose le dépôt d'une couche cristalline dite 1x3 de structure et de composition parfaitement définie, et dont la densité de pores est de préférence la plus faible possible, voire sensiblement nulle. De fait, dans les procédés de l'état de la technique, on cherche à éviter un taux de couverture total de la surface de la couche à base de nitrure d'éléments III. Or, les inventeurs ont découvert que la densité de dislocations est minimale lorsque la couche cristalline recouvre la totalité de la surface de la couche à base de nitrure d'éléments III.

Selon l'invention, l'étape de dépôt 200 de la couche cristalline 30 est donc interrompue à un instant correspondant à un maximum d'intensité lumineuse des raies intermédiaires d'ordre non-entier d'une image de diffraction suivant la direction cristallographique [1-100].

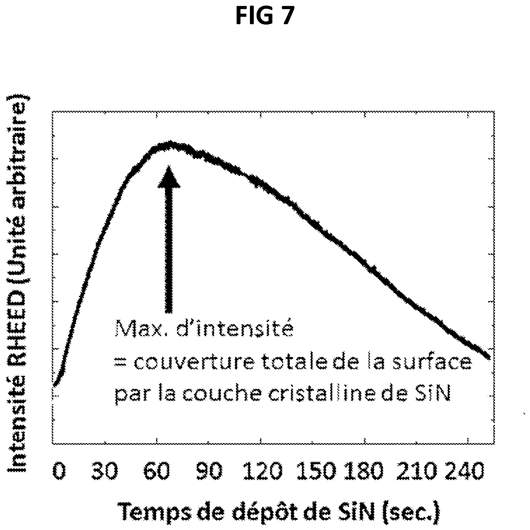

La figure 7 montre ainsi un exemple de courbe représentative de l'évolution temporelle de l'intensité d'une raie d'ordre non-entier dans une image de diffraction lors du dépôt d'une couche cristalline. On constate que cette intensité commence tout d'abord par croître entre 0 et 60 secondes, puis décroît après 90 secondes. On se situe donc entre 60 secondes et 90 secondes au niveau d'un maximum d'intensité.

Dans les conditions de dépôt de la figure 7, on interrompt donc l'étape de dépôt de la couche cristalline de passivation à un instant correspondant à un maximum d'intensité lumineuse des raies intermédiaires d'ordre non-entier d'une image de diffraction suivant la direction cristallographique [1-100] en interrompant le dépôt entre 60 et 90 secondes après son début.

Il est à noter que la couche cristalline 1x3 peut présenter une épaisseur très faible, de l'ordre de la monocouche d'atomes de silicium, soit de l'ordre de 2 à 3 Å. De fait, afin de conserver le caractère cristallin de la couche cristalline 1x3, l'épaisseur de celle-ci est de préférence inférieure à 6 Å.

Avantageusement, le dépôt de la couche cristalline 1x3 induit une passivation de la surface de la couche tampon. Cette passivation permet de rendre la couche tampon inerte vis-à-vis d'une exposition à l'air et ainsi d'empêcher toute réaction d'oxydation.

*Obtention d'un support pour la croissance de nitrure de gallium GaN*

A l'issue de l'étape de dépôt 200 de la couche cristalline 30, on obtient un support pour la croissance d'une structure semi-conductrice à base de nitrures d'éléments III, telle qu'une couche de nitrure de gallium GaN.

Puisque la couche cristalline 30 passive la surface du support, on peut retirer ledit support du réacteur dans lequel la couche cristalline 30 a été formée, par exemple pour le stocker ou pour le mettre dans un autre réacteur. La surface étant passivée, le support peut être exposé à l'air libre sans risque d'oxydation.

Ce support comprend :

- un substrat 10 choisi parmi le groupe consistant en le silicium Si, le carbure de silicium SiC, le nitrure d'aluminium AlN, l'oxyde de zinc ZnO, le saphir ou l'arséniure de gallium GaAs;
- une couche tampon 20 incluant une couche supérieure à base de nitrures d'éléments III, qui peut présenter par exemple une épaisseur comprise entre 100 $\mu$m et 200 $\mu$m ;
- une couche cristalline 30 dont l'épaisseur peut être comprise entre 2 et 6 Å, de préférence entre 2 et 3 Å.

*Croissance d'une couche de nitrure de gallium*

Le procédé comprend également une étape de croissance d'une structure semi-conductrice à base de nitrures d'éléments III, telle que la croissance d'une couche de nitrure de gallium, sur la couche cristalline 30.

On fournit donc le support obtenu précédemment, par exemple en l'introduisant dans le réacteur dans lequel va croître la couche de nitrure de gallium.

Le principe de croissance de la couche de nitrure de gallium GaN sur la couche cristalline 1x3 est le suivant.

Le dépôt de la couche cristalline 1x3 permet d'augmenter la longueur de diffusion (i.e. amplitude de diffusion caractérisant l'interaction d'un neutron avec un isotope donné) des espèces déposées sur la couche cristalline.

La couche cristalline épitaxiale forme une surface énergétiquement défavorable à la croissance bidimensionnelle de nitrures d'éléments III. Cet effet anti-surfactant induit la formation d'îlots dont la taille et la forme sont déterminées par l'énergie de surface de la couche cristalline, et par la cinétique de croissance.

Lors de l'étape de dépôt de la couche de nitrure de gallium GaN, le nitrure de gallium GaN se développe latéralement à partir des îlots, formant par coalescence une couche de nitrure de gallium GaN (croissance 3D). La croissance de la couche de nitrure de gallium est ensuite poursuivie jusqu'à l'obtention d'une épaisseur de nitrure de gallium GaN désirée (croissance 2D).

De préférence, l'étape de croissance 300 comprend la croissance, sur la couche cristalline 30, d'une couche à base de nitrures d'éléments III 40 couche présentant une épaisseur supérieure à 1 $\mu$m, et de préférence supérieure à 2 $\mu$m.

On obtient alors un empilement de couche composé d'un substrat, d'une couche tampon, d'une couche cristalline et d'une couche de nitrure de gallium.

De préférence, l'étape de croissance 300 est effectuée à une température comprise entre 950 et 1200°C, et préférence entre 1000°C et 1100°C. De préférence l'étape de croissance est effectuée en une seule fois, et ne comprend donc pas d'étape de recuit.

La densité de dislocations traversantes qui émergent en surface peut être mesurée par microscopie électronique en transmission (MET ou TEM en anglais pour "Transmission Electron Microscopy"). La densité de dislocations traversantes est inférieure ou égale à $5.10^8$ cm$^{-2}$. Le nitrure de gallium GaN présente donc une densité de dislocations traversantes réduite comparée à une couche GaN formée selon un procédé de l'état de la technique, sans la couche cristalline 1x3.

On constate que la zone de coalescence dans la couche de nitrure de gallium, au niveau de laquelle sont observés la courbure des dislocations, s'étend sur une épaisseur inférieure à 2 $\mu$m à partir de la surface de la couche cristalline 30, comme il peut être constaté par une observation au microscope électronique.

L'épaisseur de coalescence du nitrure de gallium GaN est définie comme l'épaisseur requise pour obtenir une couche de GaN entièrement coalescée, c'est-à-dire présentant un plan de surface continu. On ne peut plus distinguer d'îlots.

Bien entendu, la couche de nitrure de gallium GaN peut ensuite être séparée du substrat et de la couche tampon, par exemple pour obtenir une couche de nitrure de gallium GaN autosupportée.

*Techniques de croissance utilisée*

Avantageusement, les étapes de :

- formation de la couche tampon 20, et/ou de
- dépôt de la couche cristalline 30 sur la couche tampon 20,

peuvent être réalisées par un dépôt sous ultra-vide, de préférence par épitaxie par jets moléculaires EJM (ou « MBE » sigle de l'expression anglo-saxonne « molecular beam epitaxy »).

Il est également possible que l'étape de dépôt de la couche cristalline 30 et/ou de la couche tampon 20 consiste en un dépôt en phase vapeur, plus précisément en un dépôt par épitaxie en phase vapeur aux organométalliques EPVOM (ou « MOVPE » sigle de l'expression anglo-saxonne « Metalorganic vapour phase epitaxy »).

Le fait de former la couche tampon par épitaxie par jets moléculaires - et donc dans un environnement ultravide - présentent de nombreux avantages par rapport aux techniques de formation de la couche tampon par épitaxie en phase vapeur aux organométalliques.

Notamment, la formation de la couche tampon 20 par épitaxie par jets moléculaires permet :

- d'une part d'éliminer toute trace de gaz réactif dans l'environnement du substrat une fois la couche tampon 20 formée, et donc de limiter les risques de réaction parasite de nitruration de la surface du substrat,
- d'autre part de limiter l'encrassement du réacteur de croissance et donc d'améliorer le rendement de fabrication en diminuant la fréquence des opérations de maintenance du réacteur.

En outre, la formation de la couche tampon 20 par épitaxie par jets moléculaires permet d'obtenir une surface de la couche à base de nitrures d'éléments III qui est très lisse, améliorant ainsi la formation de la couche cristalline 30.

Par ailleurs, l'utilisation d'ultravide en EJM permet également de faire un suivi in-situ - par exemple par diffraction électronique - du dépôt de la couche cristalline. Ceci permet un suivi précis de l'étape de dépôt de la couche cristalline de sorte à stopper cette étape lorsque l'épaisseur de la couche cristalline recouvre totalement la surface.

Ainsi, le procédé peut comprendre une étape de mesure du taux de couverture de la couche cristalline 30 par diffraction d'électrons en incidence rasante suivant la direction [1-100] pendant l'étape de dépôt de la couche cristalline 30 de sorte à obtenir une image de diffraction de ladite couche cristalline 30, dans lequel la durée de l'étape de dépôt de la couche cristalline est fonction de l'intensité d'au moins une raie de diffraction d'ordre non-entier d'une image de diffraction de la couche cristalline obtenue par diffraction électronique suivant la direction cristallographique [1-100].

Comme indiqué précédemment, l'image de diffraction de la couche cristalline 30 suivant la direction [1-100] comporte alors :

- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1).

De préférence, l'étape de dépôt de la couche cristalline 30 est interrompue lorsque l'intensité lumineuse des raies intermédiaires d'ordre non-entier de l'image de diffraction (suivant la direction cristallographique [1-100]) est maximale, ce qui correspond à un taux de couverture complet de la surface de la couche à base de nitrure d'éléments III par la couche cristalline 30.

Ce maximum d'intensité est facilement identifiable. En effet, en utilisant une caméra CCD, il suffit d'enregistrer le profil d'intensité d'une des raies de diffraction d'ordre non-entier suivant la direction [1-100] en fonction du temps de dépôt de la couche de passivation. Dans un premier temps, la raie de diffraction d'ordre non-entier apparait puis son intensité s'accroît au cours du dépôt, pour arriver à un pallier avant dans un deuxième temps de décroître et finir pas disparaître. Le maximum d'intensité est donc détectable par la stabilité de cette intensité, qui peut durer plusieurs minutes ou plusieurs dizaines de seconde suivant la technique utilisée.

De même, l'étape de croissance de la structure semi-conductrice - telle qu'une couche de nitrure de gallium - peut être réalisée par un dépôt en phase vapeur tel que par EPVOM.

*Exemple de procédé de fabrication*

On va maintenant décrire un exemple de procédé selon l'invention.

Le but est ici de réaliser une couche mince de nitrure de gallium GaN sur un substrat de silicium Si, la couche de nitrure de gallium GaN présentant une faible densité de dislocation (TDD < $5.10^8$ cm$^{-2}$, où « *TDD* » est le sigle de l'expression anglo-saxonne « *Threading Dislocation Density* »).

Le substrat de silicium utilisé présente une orientation cristallographique (111).

On forme, sur le substrat de silicium, une couche tampon de nitrure d'aluminium AlN par épitaxie par jets moléculaires. La formation de la couche tampon est interrompue lorsque l'épaisseur de celle-ci est comprise entre 10 et 200 nm.

On réalise ensuite l'étape de dépôt de la couche cristalline 1x3. Un traitement de la surface de la couche tampon par épitaxie par jets moléculaires est mis en oeuvre en utilisant des atomes de silicium et des molécules d'ammoniac NH3. Ce traitement de surface conduit à la formation d'une nouvelle structure cristalline bien définie, mesurable et identifiable par diffraction électronique.

Durant le dépôt de la couche cristalline, la surface est observée par une technique de diffraction des électrons consistant à envoyer en incidence rasante un faisceau d'électrons monocinétiques sur la couche cristalline en cours de formation afin d'observer la figure de diffraction résultante (suivant la direction cristallographique [1-100]).

La structure périodique ordonnée de la couche cristalline 1x3 permet de diffracter les électrons et ainsi d'obtenir une image de diffraction spécifique.

La durée de l'étape de dépôt de la couche cristalline est fonction de l'intensité d'au moins une raie de diffraction d'ordre non-entier observée sur l'image de diffraction.

En particulier, l'étape de dépôt de la couche cristalline est interrompue lorsque l'intensité d'au moins l'une des raies de diffraction observées sur la figure de diffraction est maximale, ce qui est détectable par la stabilité de cette intensité.

On fait ensuite croître la couche de nitrure de gallium GaN. La couche cristalline permet d'initier un mode de croissance 3D du nitrure de gallium GaN. Des îlots de nitrure de gallium GaN se forment à la surface de la couche cristalline. Les îlots de nitrure de gallium GaN grossissent et finissent par former une couche coalescée au bout d'environ 2 µm.

On obtient ainsi une couche de nitrure de gallium GaN d'épaisseur 2 µm et de densité de dislocation inférieure à $4.10^8$ cm$^{-2}$.

Des exemples de couches de nitrure de gallium obtenues par d'autres procédés sont donnés à titre indicatif dans le tableau suivant.

| (technique de croissance) | Substrat | Epaisseur GaN (µm) | Densité Dislocations (cm-2) | Largeur mihauteur (002) (102) |
|---|---|---|---|---|
| Invention (**EJM+EPVOM**) | Si(111) | 2 (200nmAlN) | ~ $4 \times 10^{\wedge}8$ | 439'' 468'' |
| OSRAM (EPVOM) | Si(111) | 1.5 (AlN/AlGaN 400 nm) | > $8 \times 10^{\wedge}8$ | 450'' 570'' |

| | | | | |
|---|---|---|---|---|
| IMEC (EPVOM) | Si(111) | 1,7 (AlN/AlGaN 1,5 mm) | ~ 3×10^8 | 533" - |
| Korea PTI (EPVOM) | Si(111) | 1 | ~ 2×10^9 | 700" 1050" |
| Singapore MIT (EPVOM) | Si(111) | 2,2 | ~ 10^9 | - - |
| U. Magdebourg (EPVOM) | Si(111) | >4 | ~ 1×10^9 | - - |
| Univ. Virginie (EPVOM) | 6H-SiC | 8 | ~ 4×10^8 | 240" 300" |
| U. Cambridge (EPVOM) | Saphir | 3 | ~ 2×10^8 | 185" 325" |
| U. Cambridge (EPVOM) | Saphir | 12 | ~ 5×10^7 | 175" 170" |
| Univ. Virginie (EPVOM) | Saphir | 6 | ~ 3,5×10^7 | 205" 221" |
| Lumilog (EPVOM) | Saphir | 4 | ~ 5×10^8 | 305" 415" |
| Lumilog (EPVOM) | Saphir | 9 | ~ 8×10^7 | 240" 315" |

Comme on peut le constater sur le tableau ci-dessus, les procédés existants utilisant un substrat de silicium pour la croissance d'une couche de nitrure de gallium ne permettent pas d'obtenir une couche de nitrure de gallium de qualité équivalente au procédé selon l'invention.

Par ailleurs, on constate que même si les procédés utilisant un substrat saphir pour la croissance d'une couche de nitrure de gallium permettent d'obtenir une couche de nitrure de gallium présentant une densité de dislocation équivalente au procédé selon l'invention, l'épaisseur des couches de nitrure de gallium GaN épitaxiée est plus importante

L'homme du métier aura compris que de nombreuses modifications peuvent être apportées au procédé décrit ci-dessus sans sortir matériellement des nouveaux enseignements présentés ici.

Par exemple, les étapes consistant à former la couche tampon et à déposer la couche cristalline peuvent être réalisées par EPVOM. Par ailleurs, l'étape de croissance de la structure semi-conductrice à base de nitrures d'éléments III peut être réalisée par EJM.

Il est possible d'obtenir une diode électroluminescente à base de nitrure d'éléments nitrures d'éléments III, comprenant

- une structure semi-conductrice précédemment décrite,
- une première couche de contact à base de nitrure de gallium disposée sur la première couche de semi-conducteur à base de nitrures d'éléments III,
- une seconde couche de contact à base de nitrure de gallium disposée sur la première couche de contact à base de nitrure de gallium,
- une couche active dotée d'une structure de puits quantiques multiples disposée entre la première couche de contact à base de nitrure de gallium et la seconde couche de contact à base de nitrure de gallium.

Il est donc bien évident que les exemples qui viennent d'être donnés ne sont que des illustrations particulières en aucun cas limitatives

## Revendications

1. Procédé de fabrication d'un support pour la fabrication d'une structure semi-conductrice à base de nitrures d'éléments III **caractérisé en ce que** le procédé comprend les étapes de :

   - formation (100) d'une couche tampon (20) sur un substrat (10), ladite couche tampon comprenant une couche supérieure à base de nitrures d'éléments III,
   - dépôt (200) d'une couche cristalline (30) sur la couche tampon, ladite couche cristalline étant déposée à partir d'atomes de silicium de sorte à recouvrir la totalité de la surface de la couche supérieure à base de nitrures d'éléments III, ladite couche cristalline (30) présentant une périodicité triple d'atomes de silicium suivant la direction cristallographique [1-100] de sorte qu'une image de diffraction de ladite couche cristalline obtenue par diffraction d'électrons en incidence rasante suivant la direction [1-100] comporte :

     - une raie centrale (0, 0) et des raies d'ordre entier (0, -1) et (0, 1),
     - deux raies de diffraction d'ordre non-entier (0, -1/3) et (0, -2/3) entre la raie centrale (0, 0) et la raie d'ordre entier (0, -1), et
     - deux raies de diffraction d'ordre non-entier (0, 1/3) et (0, 2/3) entre la raie centrale (0, 0) et la raie d'ordre entier (0, 1), le procédé étant **caractérisé en ce que** ladite étape de dépôt (200) de la couche cristalline (30) est interrompue à un instant correspondant à un maximum d'intensité lumineuse des raies intermédiaires d'ordre non-entier d'une image de diffraction suivant la direction cristallographique [1-100].

2. Procédé selon la revendication 1, dans lequel la couche cristalline présente une périodicité simple suivant la direction cristallographique [1-210] de sorte qu'une image de diffraction de ladite couche cristalline obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci.

3. Procédé selon l'une des revendications précédentes, dans lequel le substrat est à base de silicium et l'étape de formation (100) de la couche tampon (20) inclut le dépôt (110) d'une couche de nitrure d'aluminium AIN (21) formant la couche de surface supérieure à base de nitrures d'éléments III.

4. Procédé selon l'une des revendications 1 ou 2, dans lequel le substrat est à base de silicium et l'étape de formation (100) de la couche tampon (20) inclut

   - le dépôt (110) d'une couche de nitrure d'aluminium AIN (21) et
   - le dépôt (120) d'une couche une couche de nitrure de gallium et d'aluminium AIGaN (22) formant la couche de surface supérieure à base de nitrures d'éléments III sur la couche de nitrure d'aluminium AIN (21).

**5.** Procédé selon l'une des revendications précédentes, dans lequel la couche tampon (20) a, à l'issue de sa formation, une épaisseur comprise entre 10 et 200 nm.

**6.** Procédé selon l'une des revendications précédentes, dans lequel l'étape de dépôt de la couche cristalline consiste en un dépôt sous ultra-vide, préférentiellement un dépôt par épitaxie par jets moléculaires.

**7.** Procédé selon la revendication précédente, comprenant une étape de mesure de la couche cristalline par diffraction d'électrons en incidence rasante dans le plan cristallin [1-100] pendant l'étape de dépôt de la couche cristalline de sorte à obtenir une image de diffraction de ladite couche cristalline, et la durée de l'étape de dépôt de la couche cristalline (30) est fonction de l'intensité d'au moins une raie de diffraction d'ordre non-entier de l'image de diffraction de la couche cristalline suivant la direction cristallographique [1-100].

**8.** Procédé selon l'une des revendications précédentes, dans lequel la couche cristalline présente une épaisseur comprise entre 2 et 6 Å.

**9.** Procédé selon la revendication 1 à 2, dans lequel l'étape de dépôt de la couche cristalline consiste en un dépôt en phase vapeur.

**10.** Procédé selon la revendication précédente, dans lequel l'étape de dépôt de la couche cristalline consiste en un dépôt par épitaxie en phase vapeur aux organométalliques.

**11.** Procédé selon l'une quelconques des revendications précédentes, dans lequel la couche cristalline est déposée à partir d'atomes de silicium et de molécules d'ammoniac.

**12.** Support pour la fabrication d'une structure semi-conductrice à base de nitrures d'éléments III, **caractérisé en ce qu'**il comprend :

- un substrat (10),
- une couche tampon (20) sur le substrat, la couche tampon comprenant une couche supérieure à base de nitrures d'éléments III,
- une couche cristalline (30) sur la couche tampon, ladite couche cristalline incluant des atomes de silicium et recouvrant la totalité de la surface de la couche supérieure à base de nitrures d'éléments III de la couche tampon, ladite couche cristalline (30) présentant une périodicité triple d'atomes de silicium suivant la direction [1-100], de sorte qu'une image de diffraction de ladite couche cristalline obtenue par diffraction d'électrons en incidence rasante suivant la direction [1-100] comporte :
- une raie centrale (0, 0) et des raies d'ordre entier (0, -1) et (0, 1),
- deux raies de diffraction d'ordre non-entier (0, -1/3) et (0, -2/3) entre la raie centrale (0, 0) et la raie d'ordre entier (0, -1), et
- deux raies de diffraction d'ordre non-entier (0, 1/3) et (0, 2/3) entre la raie centrale (0, 0) et la raie d'ordre entier (0, 1),

**caractérisé en ce que** l'état de ladite couche cristalline correspond à un maximum d'intensité lumineuse des raies intermédiaires d'ordre non-entier d'une image de diffraction suivant la direction cristallographique [1-100].

**13.** Support selon la revendication 12, dans lequel la couche cristalline présente une périodicité simple suivant la direction cristallographique [1-210] de sorte qu'une image de diffraction de ladite couche cristalline obtenue par diffraction d'électrons en incidence rasante suivant la direction [1-210] comporte une raie centrale (0, 0) et des raies d'ordre entier (0, -1) et (0, 1) sans raies d'ordre non-entier entre celles-ci.

**14.** Support selon l'une quelconque des revendications 13 à 14, dans lequel le substrat (10) est à base de saphir Al2O3, de silicium Si, de silicium sur isolant SOI, de carbure de silicium SiC, de nitrure d'aluminium AIN, d'oxyde de zinc ZnO ou d'arséniure de gallium GaAs.

**15.** Support selon l'une quelconque des revendications 12 à 14 dans lequel le substrat (10) est à base de silicium et la couche tampon comprend une couche de nitrure d'aluminium AIN (21) et une couche de nitrure de gallium et d'aluminium AIGaN (22) sur la couche de nitrure d'aluminium AIN (21).

**16.** Support selon l'une des revendications 12 à 15, dans lequel la couche cristalline présente une épaisseur comprise entre 2 Å et 6 Å.

**17.** Support selon l'une des revendications 12 à 16, dans lequel la couche tampon (20) a une épaisseur comprise entre 10 et 200 nm.

**18.** Procédé de fabrication d'une structure semi-conductrice à base de nitrures d'éléments III, comprenant les étapes de

- fourniture d'un support selon l'une quelconque des revendications 12 à 17,
- croissance (300) d'une structure semi-conductrice à base de nitrures d'éléments III (40) sur la couche cristalline (30).

**19.** Procédé selon la revendication 18, dans lequel l'étape de croissance (300) est effectuée à une température comprise entre 950 et 1200°C.

**20.** Procédé selon l'une des revendications 18 à 19, dans lequel l'étape de croissance (300) ne comprend pas d'étape de recuit.

**21.** Procédé selon l'une des revendications 18 à 20, dans lequel l'étape de croissance (300) comprend la croissance d'une couche à base de nitrures d'éléments III (40) sur la couche cristalline (30) présentant une épaisseur supérieure à 1 $\mu$m, et de préférence supérieure à 2 $\mu$m.

**22.** Procédé selon l'une des revendications 18 à 21, dans lequel l'étape de croissance (300) comprend une étape de dépôt d'une couche de nitrure de gallium GaN sur la couche cristalline (30).

**23.** Procédé selon l'une des revendications 18 à 22, dans lequel l'étape de croissance (300) consiste en un dépôt par épitaxie en phase vapeur aux organométalliques.

**24.** Structure semi-conductrice à base de nitrures d'éléments III, **caractérisé en ce que** ladite structure comprend :

- un support selon l'une quelconque des revendications 12 à 17,
- un matériau semi-conducteur à base de nitrures d'éléments III sur la couche cristalline (30).

**25.** Structure selon la revendication précédente, dans lequel le matériau semi-conducteur à base de nitrures d'éléments III sur la couche cristalline (30) comprend une couche de nitrure de gallium.

**26.** Structure selon la revendication précédente, dans lequel le nitrure de gallium GaN présente une densité de dislocations traversantes inférieure ou égale à $5.10^8$ cm$^{-2}$.

**27.** Structure selon la revendication précédente, dans lequel le matériau semi-conducteur à base de nitrures d'éléments III sur la couche cristalline (30) comprend une couche à base d'aluminium.

**28.** Diode électroluminescente à base de nitrures d'éléments III, **caractérisé en ce qu'**elle comprend

- une structure semi-conductrice selon l'une des revendications 23 à 26
- une première couche de contact à base de nitrure de gallium disposée sur la première couche de semi-conducteur à base de nitrures d'éléments III,
- une seconde couche de contact à base de nitrure de gallium disposée sur la première couche de contact à base de nitrure de gallium,
- une couche active dotée d'une structure de puits quantiques multiples disposée entre la première couche de contact à base de nitrure de gallium et la seconde couche de contact à base de nitrure de gallium.

**Patentansprüche**

**1.** Verfahren zur Herstellung eines Trägers für die Herstellung einer Halbleiterstruktur auf der Basis von Nitriden von Elementen der III. Hauptgruppe, **dadurch gekennzeichnet, dass** das Verfahren die folgenden Schritte umfasst:

- Bilden (100) einer Pufferschicht (20) auf einem Substrat (10), wobei die Pufferschicht eine obere Schicht auf der Basis von Nitriden von Elementen der III. Hauptgruppe umfasst,

- Abscheiden (200) einer kristallinen Schicht (30) auf der Pufferschicht, wobei die kristalline Schicht auf der Basis von Siliziumatomen abgeschieden wird, um die gesamte Oberfläche der oberen Schicht auf der Basis von Nitriden von Elementen der III. Hauptgruppe zu bedecken, wobei die kristalline Schicht (30) eine dreifache Periodizität von Siliziumatomen entlang der kristallographischen Richtung [1-100] aufweist, sodass ein Beugungsbild der kristallinen Schicht, das durch Beugung von Elektronen bei streifendem Einfall entlang der Richtung [1-100] erhalten wird, Folgendes aufweist:

- eine zentrale Linie (0, 0) und Linien ganzzahliger Ordnung (0, -1) und (0, 1),

- zwei Beugungslinien nicht-ganzzahliger Ordnung (0, -1/3) und (0, -2/3) zwischen der zentralen Linie (0, 0) und der Linie ganzzahliger Ordnung (0, -1), und

- zwei Beugungslinien nicht-ganzzahliger Ordnung (0, 1/3) und (0, 2/3) zwischen der zentralen Linie (0, 0) und der Linie ganzzahliger Ordnung (0, 1),

wobei das Verfahren **dadurch gekennzeichnet ist, dass** der Schritt (200) des Abscheidens der kristallinen Schicht (30) zu einem Zeitpunkt unterbrochen wird, der einem Maximum einer Lichtintensität der Zwischenlinien nicht-ganzzahliger Ordnung eines Beugungsbildes entlang der kristallographischen Richtung [1-100] entspricht.

2. Verfahren nach Anspruch 1, wobei die kristalline Schicht eine einfache Periodizität entlang der kristallographischen Richtung [1-210] aufweist, sodass ein Beugungsbild der kristallinen Schicht, das durch Beugung von Elektronen bei streifendem Einfall entlang der Richtung [1-210] erhalten wird, eine zentrale Linie (0, 0) und Linien ganzzahliger Ordnung (0, -1) und (0, 1) ohne Linien nicht-ganzzahliger Ordnung dazwischen aufweist.

3. Verfahren nach einem der vorhergehenden Ansprüche, wobei das Substrat auf Siliziumbasis ist und der Schritt (100) des Bildens der Pufferschicht (20) das Abscheiden (110) einer Schicht aus Aluminiumnitrid AlN (21) einschließt, die die obere Oberflächenschicht auf der Basis von Nitriden von Elementen der III. Hauptgruppe bildet.

4. Verfahren nach Anspruch 1 oder 2, wobei das Substrat auf Siliziumbasis ist und der Schritt (100) des Bildens der Pufferschicht (20) Folgendes einschließt:

- Abscheiden (110) einer Schicht aus Aluminiumnitrid AlN (21) und
- Abscheiden (120) einer Schicht aus Gallium- und Aluminiumnitrid AlGaN (22), die die obere Oberflächenschicht auf der Basis von Nitriden von Elementen der III. Hauptgruppe auf der Aluminiumnitridschicht AlN (21) bildet.

5. Verfahren nach einem der vorhergehenden Ansprüche, wobei die Pufferschicht (20) nach ihrer Bildung eine Dicke zwischen 10 und 200 nm aufweist.

6. Verfahren nach einem der vorhergehenden Ansprüche, wobei der Schritt des Abscheidens der kristallinen Schicht aus einer Ultrahochvakuumabscheidung, vorzugsweise einer Abscheidung durch Molekularstrahlepitaxie, besteht.

7. Verfahren nach dem vorhergehenden Anspruch, das einen Schritt des Messens der kristallinen Schicht durch Beugung von Elektronen bei streifendem Einfall in der [1-100]-Kristallebene während des Schritts des Abscheidens der kristallinen Schicht umfasst, um ein Beugungsbild der kristallinen Schicht zu erhalten, und die Dauer des Schrittes des Abscheidens der kristallinen Schicht (30) von der Intensität mindestens einer Beugungslinie nicht-ganzzahliger Ordnung des Beugungsbildes der kristallinen Schicht entlang der kristallographischen Richtung [1-100] abhängig ist.

8. Verfahren nach einem der vorhergehenden Ansprüche, wobei die kristalline Schicht eine Dicke zwischen 2 und 6 Å aufweist.

9. Verfahren nach Anspruch 1 bis 2, wobei der Schritt des Abscheidens der kristallinen Schicht aus einer Dampfphasenabscheidung besteht.

10. Verfahren nach dem vorhergehenden Anspruch, wobei der Schritt des Abscheidens der kristallinen Schicht aus einer Abscheidung durch metallorganische Gasphasenepitaxie besteht.

11. Verfahren nach einem der vorhergehenden Ansprüche, wobei die kristalline Schicht aus Siliziumatomen und Ammoniakmolekülen abgeschieden wird.

**12.** Träger für die Herstellung einer Halbleiterstruktur auf der Basis von Nitriden von Elementen der III. Hauptgruppe, **dadurch gekennzeichnet, dass** er Folgendes umfasst:

- ein Substrat (10),
- eine Pufferschicht (20) auf dem Substrat, wobei die Pufferschicht eine obere Schicht auf der Basis von Nitriden von Elementen der III. Hauptgruppe umfasst,
- eine kristalline Schicht (30) auf der Pufferschicht, wobei die kristalline Schicht Siliziumatome einschließt und die gesamte Oberfläche der oberen Schicht auf der Basis von Nitriden von Elementen der III. Hauptgruppe der Pufferschicht bedeckt, wobei die kristalline Schicht (30) eine dreifache Periodizität von Siliziumatomen entlang der Richtung [1-100] aufweist, sodass ein Beugungsbild der kristallen Schicht, das durch Beugung von Elektronen bei streifendem Einfall in der [1-100]-Richtung erhalten wird, Folgendes aufweist:
- eine zentrale Linie (0, 0) und Linien ganzzahliger Ordnung (0, -1) und (0, 1),
- zwei Beugungslinien nicht-ganzzahliger Ordnung (0, -1/3) und (0, -2/3) zwischen der zentralen Linie (0, 0) und der Linie ganzzahliger Ordnung (0, -1), und
- zwei Beugungslinien nicht-ganzzahliger Ordnung (0, 1/3) und (0, 2/3) zwischen der zentralen Linie (0, 0) und der Linie ganzzahliger Ordnung (0, 1),

**dadurch gekennzeichnet, dass** der Zustand der kristallinen Schicht einem Maximum von Lichtintensität der Zwischenlinien nicht-ganzzahliger Ordnung eines Beugungsbildes entlang der kristallographischen Richtung [1-100] entspricht.

**13.** Träger nach Anspruch 12, wobei die kristalline Schicht eine einfache Periodizität entlang der kristallographischen Richtung [1-210] aufweist, sodass ein Beugungsbild der kristallinen Schicht, das durch Beugung von Elektronen bei streifendem Einfall entlang der Richtung [1-210] erhalten wird, eine zentrale Linie (0, 0) und Linien ganzzahliger Ordnung (0, -1) und (0, 1) ohne Linien nicht-ganzzahliger Ordnung dazwischen aufweist.

**14.** Träger nach einem der Ansprüche 13 bis 14, wobei das Substrat (10) auf Basis von Saphir Al2O3, Silizium Si, Silizium auf einem Isolator SOI, Siliziumcarbid SiC, Aluminiumnitrid AlN, Zinkoxid ZnO oder Galliumarsenid GaAs ist.

**15.** Träger nach einem der Ansprüche 12 bis 14, wobei das Substrat (10) auf Basis von Silizium ist und die Pufferschicht eine Schicht aus Aluminiumnitrid AlN (21) und eine Schicht aus Gallium- und Aluminiumnitrid AlGaN (22) auf der Schicht aus Aluminiumnitrid AlN (21) umfasst.

**16.** Träger nach einem der Ansprüche 12 bis 15, wobei die kristalline Schicht eine Dicke zwischen 2 Å und 6 Å aufweist.

**17.** Träger nach einem der Ansprüche 12 bis 16, wobei die Pufferschicht (20) eine Dicke zwischen 10 und 200 nm aufweist.

**18.** Verfahren zur Herstellung einer Halbleiterstruktur auf der Basis von Nitriden von Elementen der III. Hauptgruppe, das die folgenden Schritte umfasst:

- Bereitstellen eines Trägers nach einem der Ansprüche 12 bis 17,
- Wachstum (300) einer Halbleiterstruktur (40) auf der Basis von Nitriden von Elementen der III. Hauptgruppe auf der kristallinen Schicht (30).

**19.** Verfahren nach Anspruch 18, wobei der Wachstumsschritt (300) bei einer Temperatur zwischen 950 und 1 200 °C durchgeführt wird.

**20.** Verfahren nach einem der Ansprüche 18 bis 19, wobei der Wachstumsschritt (300) keinen Glühschritt umfasst.

**21.** Verfahren nach einem der Ansprüche 18 bis 20, wobei der Wachstumsschritt (300) das Wachstum einer Schicht (40) aus Nitriden von Elementen der III Hauptgruppe auf der kristallinen Schicht (30) mit einer Dicke von mehr als 1 $\mu$m, und vorzugsweise mehr als 2 $\mu$m umfasst.

**22.** Verfahren nach einem der Ansprüche 18 bis 21, wobei der Wachstumsschritt (300) einen Schritt des Abscheidens einer Schicht aus Galliumnitrid GaN auf der kristallinen Schicht (30) umfasst.

**23.** Verfahren nach einem der Ansprüche 18 bis 22, wobei der Wachstumsschritt (300) aus einer Abscheidung durch metallorganische Gasphasenepitaxie besteht.

**24.** Halbleiterstruktur auf der Basis von Nitriden von Elementen der III. Hauptgruppe, **dadurch gekennzeichnet, dass** die Struktur Folgendes umfasst:

- einen Träger nach einem der Ansprüche 12 bis 17,
- ein Halbleitermaterial auf der Basis von Nitriden von Elementen der III. Hauptgruppe auf der kristallinen Schicht (30).

**25.** Struktur nach dem vorhergehenden Anspruch, wobei das Halbleitermaterial auf der Basis von Nitriden von Elementen der III. Hauptgruppe auf der kristallinen Schicht (30) eine Schicht aus Galliumnitrid umfasst.

**26.** Struktur nach dem vorhergehenden Anspruch, wobei das Galliumnitrid GaN eine Fadenversetzungsdichte gleich oder kleiner $5{,}10^8$ cm$^{-2}$ aufweist.

**27.** Struktur nach dem vorhergehenden Anspruch, wobei das Halbleitermaterial auf der Basis von Nitriden von Elementen der III. Hauptgruppe auf der kristallinen Schicht (30) eine Schicht auf Aluminiumbasis umfasst.

**28.** Leuchtdiode auf der Basis von Nitriden von Elementen der III. Hauptgruppe, **dadurch gekennzeichnet, dass** sie Folgendes umfasst:

- eine Halbleiterstruktur nach einem der Ansprüche 23 bis 26;
- eine erste Kontaktschicht auf der Basis von Galliumnitrid, die auf der ersten Halbleiterschicht auf der Basis von Nitriden von Elementen der III. Hauptgruppe angeordnet ist,
- eine zweite Kontaktschicht auf Galliumnitridbasis, die auf der ersten Kontaktschicht auf Galliumnitridbasis angeordnet ist,
- eine aktive Schicht, die mit einer Mehrfach-Quantentopf-Struktur versehen ist, die zwischen der ersten Kontaktschicht auf Galliumnitridbasis und der zweiten Kontaktschicht auf Galliumnitridbasis angeordnet ist.

**Claims**

**1.** Method for producing a support for producing a semiconductor structure based on group III nitrides, **characterized in that** the method comprises the steps of:

- forming (100) a buffer layer (20) on a substrate (10), said buffer layer comprising an upper layer based on group III nitrides,
- depositing (200) a crystalline layer (30) on the buffer layer, said crystalline layer being deposited from silicon atoms so as to cover the entire surface of the upper layer based on group III nitrides, said crystalline layer (30) having a triple periodicity of silicon atoms in the crystallographic direction [1-100] such that a diffraction image of said crystalline layer obtained by grazing-incidence diffraction of electrons in the direction [1-100] has:
- a central line (0, 0) and integer order lines (0, -1) and (0, 1),
- two fractional order diffraction lines (0, -1/3) and (0, -2/3) between the central line (0, 0) and the integer order line (0, -1), and
- two fractional order diffraction lines (0, 1/3) and (0, 2/3) between the central line (0, 0) and the integer order line (0, 1),

the method being **characterized in that** said crystalline layer (30) depositing step (200) is interrupted at an instant corresponding to a maximum luminous intensity of the intermediate fractional order lines of a diffraction image in the crystallographic direction [1-100].

**2.** Method according to claim 1, wherein the crystalline layer has a single periodicity in the crystallographic direction [1-210] such that a diffraction image of said crystalline layer obtained by grazing-incidence diffraction of electrons in the direction [1-210] has a central line (0, 0) and integer order lines (0, -1) and (0, 1) without fractional order lines between them.

**3.** Method according to any one of the preceding claims, wherein the substrate is based on silicon and the step of forming (100) the buffer layer (20) includes depositing (110) an aluminium nitride AlN layer (21) forming the upper surface layer based on group III nitrides.

4.  Method according to claim 1 or 2, wherein the substrate is based on silicon and the step of forming (100) the buffer layer (20) includes:

    - depositing (110) an aluminium nitride AlN layer (21) and
    - depositing (120) a gallium and aluminium nitride AlGaN layer (22) forming the upper surface layer based on group III nitrides on the aluminium nitride AlN layer (21).

5.  Method according to any one of the preceding claims, wherein the buffer layer (20) has, at the end of its forming, a thickness comprised between 10 and 200 nm.

6.  Method according to any one of the preceding claims, wherein the step of depositing the crystalline layer consists of an ultra-vacuum deposition, preferentially a deposition by molecular beam epitaxy.

7.  Method according to the preceding claim, comprising a step of measuring the crystalline layer by grazing-incidence diffraction of electrons in the crystalline plane [1-100] during the step of deposition of the crystalline layer so as to obtain a diffraction image of said crystalline layer, and the duration of the step of deposition of the crystalline layer (30) is a function of the intensity of at least one fractional order diffraction line of the diffraction image of the crystalline layer in the crystallographic direction [1-100].

8.  Method according to any one of the preceding claims, wherein the crystalline layer has a thickness comprised between 2 and 6 Å.

9.  Method according to claim 1 to 2, wherein the step of depositing the crystalline layer consists of a vapour phase deposition.

10. Method according to the preceding claim, wherein the step of depositing the crystalline layer consists of a deposition by metal organic vapour phase epitaxy.

11. Method according to any one of the preceding claims, wherein the crystalline layer is deposited from silicon atoms and ammonia molecules.

12. Support for producing a semiconductor structure based on group III nitrides, **characterized in that** it comprises:

    - a substrate (10),
    - a buffer layer (20) on the substrate, the buffer layer comprising an upper layer based on group III nitrides,
    - a crystalline layer (30) on the buffer layer, said crystalline layer including silicon atoms and covering the entire surface of the upper layer based on group III nitrides of the buffer layer, said crystalline layer (30) having a triple periodicity of silicon atoms in the direction [1-100], such that a diffraction image of said crystalline layer obtained by grazing-incidence diffraction of electrons in the direction [1-100] has:
    - a central line (0, 0) and integer order lines (0, -1) and (0, 1),
    - two fractional order diffraction lines (0, -1/3) and (0, -2/3) between the central line (0, 0) and the integer order line (0, -1), and
    - two fractional order diffraction lines (0, 1/3) and (0, 2/3) between the central line (0, 0) and the integer order line (0, 1),

    **characterized in that** the state of the crystalline layer corresponds to a maximum luminous intensity of the intermediate fractional order lines of a diffraction image in the crystallographic direction [1-100].

13. Support according to claim 12, wherein the crystalline layer has a single periodicity in the crystallographic direction [1-210] such that a diffraction image of said crystalline layer obtained by grazing-incidence diffraction of electrons in the direction [1-210] has a central line (0, 0) and integer order lines (0, -1) and (0, 1) without fractional order lines between them.

14. Support according to any one of claims 13 to 14, wherein the substrate (10) is based on sapphire Al2O3, silicon Si, silicon on insulator SOI, silicon carbide SiC, aluminium nitride AlN, zinc oxide ZnO or gallium arsenide GaAs.

15. Support according to any one of claims 12 to 14, wherein the substrate (10) is based on silicon and the buffer layer comprises an aluminium nitride AlN layer (21) and a gallium and aluminium nitride AlGaN layer (22) on the aluminium nitride AlN layer (21).

16. Support according to one of claims 12 to 15, wherein the crystalline layer has a thickness comprised between 2 Å and 6 Å.

17. Support according to one of claims 12 to 16, wherein the buffer layer (20) has a thickness comprised between 10 and 200 nm.

18. Method for producing a semiconductor structure based on group III nitrides, comprising the steps of:

   - providing a support according to any one of claims 12 to 17,
   - growing (300) a semiconductor structure based on group III nitrides (40) on the crystalline layer (30).

19. Method according to claim 18, wherein the step of growing (300) is carried out at a temperature comprised between 950 and 1 200 °C.

20. Method according to one of claims 18 to 19, wherein the step of growing (300) does not comprise an annealing step.

21. Method according to one of claims 18 to 20, wherein the step of growing (300) comprises the growing of a layer based on group III nitrides (40) on the crystalline layer (30) having a thickness greater than 1 $\mu$m, and preferably greater than 2 $\mu$m.

22. Method according to one of claims 18 to 21, wherein the step of growing (300) comprises a step of depositing a gallium nitride GaN layer on the crystalline layer (30).

23. Method according to one of claims 18 to 22, wherein the step of growing (300) consists of a deposition by metal organic vapour phase epitaxy.

24. Semiconductor structure based on group III nitrides, **characterized in that** the structure comprises:

   - a support according to any one of claims 12 to 17,
   - a semiconductor material based on group III nitrides on the crystalline layer (30).

25. Structure according to the preceding claim, wherein the semiconductor material based on group III nitrides on the crystalline layer (30) comprises a gallium nitride layer.

26. Structure according to the preceding claim, wherein the gallium nitride GaN has a threading dislocation density less than or equal to $5.10^8$ cm$^{-2}$.

27. Structure according to the preceding claim, wherein the semiconductor material based on group III nitrides on the crystalline layer (30) comprises an aluminium-based layer.

28. Light-emitting diode based on group III nitrides, **characterized in that** it comprises:

   - a semiconductor structure according to one of claims 23 to 26,
   - a first contact layer based on gallium nitride arranged on the first semiconductor layer based on group III nitrides,
   - a second contact layer based on gallium nitride arranged on the first contact layer based on gallium nitride,
   - an active layer provided with a structure of multiple quantum wells arranged between the first contact layer based on gallium nitride and the second contact layer based on gallium nitride.

## FIG 1

Formation d'une
Couche tampon
100

Dépôt d'une couche d'AlN
110

Dépôt d'une couche
d'AlGaN
120

dépôt de la couche cristalline
1x3
200

Croissance d'une couche GaN
300

## FIG 2

40 — GaN

30 —

AlGaN

20 — 22 — AlN

21 —

10 — Substrat

**FIG 3**

33

31

31

32

35

35

34

(0,-1)  (0,-2/3)  (0,-1/3)  (0,1/3)  (0,2/3)  (0,1)

(0,0)

[1-100]

**FIG 4**

43

42

44

(0,-1)  (0,0)  (0,1)

[1-210]

## FIG 5

40

30

20 { 22
      21

11

GaN

AlGaN

AlN

Substrat

10

## FIG 6

12

40

30

20 { 22
      21

GaN

AlGaN

AlN

10

**FIG 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 10151092 A1
- WO 2007133603 A2
- US 20040137732 A

**Littérature non-brevet citée dans la description**

- **SAKAI et al.** A New Method of Reducing Dislocation Density in GaN Layer Grown on Sapphire Substrate by MOVPE. *J. Cryst. Growth,* 2000, vol. 221, 334
- **S. TANAKA et al.** Anti-Surfactant in III-Nitride Epitaxy - Quantum Dot Formation and Dislocation Termination. *Jap. J. Appl. Phys.,* 2000, vol. 39
- **F. YUN et al.** Efficacy of single and double SiNx interlayers on defect réduction in GaN overlayers grown by organometallic vapor-phase epitaxy. *J. Appl. Phys.,* 2005, vol. 98, 123502
- **T. MARKURT et al.** Blocking Growth by Electrically Active Subsurface Layer : The Effects of Si as an Antisurfactant in the Growth of GaN. *Physical Review Letters,* 2013, vol. 110, 036103
- The rôle of Si as surfactant and donor in molecular-beam epitaxy of AIN. **LEBEDEV V. et al.** Journal of Applied Physics. Institute of Physics, 04 Novembre 2005, vol. 98, 93508-093508
- **AYAHIKO ICHIMIYA ; PHILIP I. COHEN.** Reflection High Energy Electron Diffraction. Cambridge University Press, 2004